# EUROPEAN PATENT APPLICATION

(11) **EP 1 001 458 A1**
(43) Date of publication of application: **17.05.2000**
(21) Application number: 98830673.4
(22) Date of filing: 09.11.1998
(51) Int. Cl.: H01L 21/3065

(54) **Isotropic etching of silicon using hydrogen chloride**

(71) Applicant: STMicroelectronics S.r.l., 20041 Agrate Brianza (Milano) (IT)
(72) Inventor: Barlocchi, Gabriele, 20010 Cornaredo (Milano) (IT); Villa, Flavio, 20159 Milano (IT)
(74) Representative: Maggioni, Claudio

(57) **Abstract**

The subject of the present invention is a method of forming isotropic recesses in a silicon "wafer".

In particular, the present invention relates to a method for isotropic etching of a silicon wafer, comprising the steps of:
- providing a silicon wafer having a protective mask of silicon nitride,
- putting the silicon wafer into contact with gaseous hydrogen chloride.

## Description

The subject of the present invention is a method of forming isotropic recesses in a silicon "wafer".

The technology of integrated circuits used in microelectronics is based essentially on the use of crystals of a semiconductor material, usually silicon.

For this purpose, a high-purity silicon crystal is grown and is then suitably processed to produce thin sheets of crystalline silicon which are commonly known by the English term "wafers". The integrated circuit is then formed on the surface of the silicon wafer by widely-known deposition, hollowing and doping techniques.

The hollowing techniques in particular permit permanent reproduction, on the silicon wafer, of the geometry of the device to be formed. These hollowing techniques provide for chemical etching of the silicon which may be performed with acid chemical reagents ("wet etching") or, more typically, for physical or chemico-physical etching with plasma or gas in the ionized state ("dry etching").

It should be noted that "wet etching" involves isotropic etching of the silicon, whereas "dry etching" is characterized by generally anisotropic etching.

Chemical "wet etching" is usually performed with the use of acid solutions having various compositions. A first example of a solution used is a mixture of hydrofluoric acid (HF), nitric acid (HNO₃), phosphoric acid (H₃PO₄) and sulphuric acid (H₂SO₄). However, this solution is characterized by an excessively fast etching rate which, according to the ratio between the various components, may vary from 8-10 µm/min (for a composition HF 0.63 : HNO₃ 3 : H₃PO₄ 1 : H₂SO₄ :0.5) to 50-60 µm/min (for a composition HF 1.25 : HNO₃ 1 : H₃PO₄ 0.5 : H₂SO₄ 0.5) . This fast etching rate is difficult to control and therefore leads to the removal of too much silicon from the surface of the wafer.

Another commonly-used solution has the following composition: HF 1 : HNO₃ 3: acetic acid (CH₃COOH) 8. This solution also presents problems since it gives rise to "staining" - that is, mottling - on the surface of the silicon wafer due to the formation of silicon monoxide (SiO). The silicon monoxide thus formed is not removed by the hydrofluoric acid but only by extremely aggressive solutions such as those described above which, however, as stated, cause the removal of considerable quantities of silicon.

The problem upon which the present invention is based is that of providing a method of forming isotropic recesses in silicon which overcomes the above-mentioned problems of the prior art.

This problem is solved by a method for isotropic etching of a silicon wafer comprising the steps of:
- providing a silicon wafer having a protective mask,
- putting the silicon wafer into contact with gaseous hydrogen chloride.

The reaction of the etching of the silicon by the hydrogen chloride is as follows:

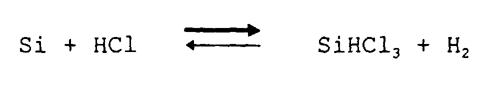

A first advantage of the present method is that the rate of etching of the silicon is slower than with the solution of the prior art described above, generally being between 200 Å/min and 1-2 µm/min, according to the etching temperature, the crystallographic planes and other influencing factors.

A second advantage is that the method of the present invention does not give rise to "staining".

It may also be noted that this reaction is the reverse of that used for the epitaxial growth of a silicon layer. This results in a third advantage of this method of the present invention which is that the isotropic etching reaction can be performed in a normal epitaxial reactor usually used for the growth reaction.

The silicon wafer is prepared beforehand by the deposition of a suitable protective layer and subsequent preliminary etching of this layer to form a protective mask which leaves uncovered some regions of the silicon surface reproducing the geometry of the microelectronic device to be produced. The protective mask may be made, for example, of silicon carbide or, preferably, of silicon nitride.

Both the deposition of the protective mask and the preliminary etching thereof are performed by means of widely known techniques which do not form the subject of the present patent application.

The use of silicon nitride as the protective mask is particularly advantageous by virtue of the considerable selectivity of the etching of the silicon, in comparison with silicon nitride, by the hydrogen chloride, this selectivity being of the order of 100:1.

In addition, a layer of silicon dioxide (SiO₂) may also be deposited or grown in an intermediate position between the silicon layer and the protective mask. This SiO₂ layer has the function of preventing direct contact between the protective layer of silicon carbide or nitride and the underlying silicon layer, which contact could generate "stress" in the silicon layer. Naturally, the SiO₂ layer will also have to undergo preliminary etching so as to leave exposed the areas of the silicon surface corresponding to the geometry of the device. Both the deposition and the preliminary etching of the SiO₂ layer are performed by techniques widely known to an expert in the art.

The reaction for etching with HCl gas is performed at temperatures above 1000°C, preferably between 1050 and 1150°C.

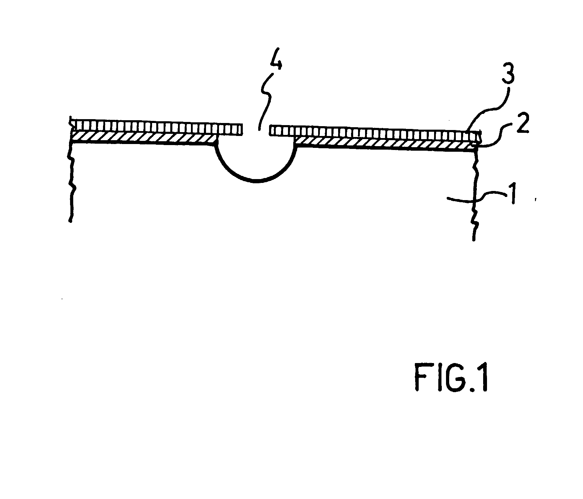

As stated this etching is isotropic, as can be seen from Figure 1, which is a partially-sectioned view of a silicon wafer in which a typical etching configuration is shown.

With reference to Figure 1, this shows the silicon layer, indicated 1, on which a layer 2 of silicon dioxide and a layer 3 of silicon nitride are deposited.

The layers of silicon dioxide and nitride undergo preliminary etching so as to create openings 4 the surface shape of which reproduces the geometry of the device to be produced.

The hydrogen chloride can come into contact with the silicon through these openings, reacting with the silicon in accordance with the reaction given above. The profile of the edges of the recess reproduced in Figure 1 is substantially a quarter-circle and is typical of isotropic etching.

As stated, the etching reaction is performed on the silicon wafer in an epitaxial reactor of known type.

In a typical example of the implementation of the method of the present invention, the reactor containing the silicon wafer is heated to an initial temperature of about 850°C, a stream of hydrogen (60 litres/minute) is then introduced into the reactor and is maintained throughout the process.

The temperature is then raised from about 850°C to about 1000°C over a period of about 1 minute.

After a gas-stabilization stage, still at about 1000°C and of about 20 seconds' duration, a flow of gaseous hydrogen chloride (500 cc/minute) is admitted to the reactor for a period variable in dependence on the depth of the recess to be formed.

The supply of hydrogen chloride is then gradually stopped over a period of about 20 seconds and the reactor is cooled to the starting temperature.

## Claims

1. A method for isotropic etching of a silicon wafer comprising the steps of:
- providing a silicon wafer having a protective mask,
- putting the silicon wafer into contact with gaseous hydrogen chloride.

2. A method according to Claim 1, in which the protective mask is made of silicon nitride.

3. A method according to Claim 1, in which the protective mask is made of silicon carbide.

4. A method according to Claims 1 to 3, in which a layer of silicon dioxide is interposed between the protective mask and the silicon wafer.

5. A method according to Claims 1 to 4, in which the step of putting the silicon wafer into contact with hydrogen chloride is performed at a reaction temperature above 1000°C.

6. A method according to Claim 5, in which the reaction temperature is between 1050 and 1150°C.

7. A method according to Claims 1 to 6, in which the step of putting the silicon wafer into contact with the hydrogen chloride is performed in a stream of hydrogen.

8. A method according to Claim 7, in which the flow of the hydrogen is 60 litres/minute.

9. A method according to Claims 1 to 8, in which, during the step of putting the silicon wafer into contact with the hydrogen chloride, the hydrogen chloride is admitted to the reactor with a flow of 500 cc/minute.

10. A method according to Claims 1 to 9, in which the method is performed in an epitaxial reactor.
